(19) Europäisches Patentamt / European Patent Office / Office européen des brevets

(11) **EP 4 421 857 A1**

(12) **EUROPEAN PATENT APPLICATION**

(43) Date of publication:
**28.08.2024 Bulletin 2024/35**

(21) Application number: **24158605.6**

(22) Date of filing: **20.02.2024**

(51) International Patent Classification (IPC):
*H01L 21/67* (2006.01)    *H01L 21/683* (2006.01)
*H01L 21/687* (2006.01)

(52) Cooperative Patent Classification (CPC):
**H01L 21/6838; H01L 21/67253; H01L 21/67259;
H01L 21/67288; H01L 21/68742**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.02.2023 JP 2023027318**

(71) Applicant: **Canon Kabushiki Kaisha
Tokyo 146-8501 (JP)**

(72) Inventors:
• **NAKAJIMA, Kazunori
Tokyo, 146-8501 (JP)**
• **KOYA, Shigeo
Tokyo, 146-8501 (JP)**
• **KORENAGA, Nobushige
Tokyo, 146-8501 (JP)**

(74) Representative: **Canon Europe Limited
European Intellectual Property Group
4 Roundwood Avenue
Stockley Park
Uxbridge UB11 1AF (GB)**

(54) **STAGE APPARATUS, LITHOGRAPHY APPARATUS, AND ARTICLE MANUFACTURING METHOD**

(57) A stage apparatus includes a substrate chuck configured to attract and hold a substrate, a pin configured to be able to attract and hold the substrate, the pin being configured to be able to protrude from the substrate chuck through a hole in the substrate chuck, a driving portion configured to move one of the substrate chuck and the pin relative to the other of the substrate chuck and the pin, and a control portion configured to control the driving portion, wherein in a case where the substrate and the substrate chuck separate from each other, the control portion controls the driving portion based on a first condition related to easiness of separation between the substrate and the substrate chuck.

## FIG.8

EP 4 421 857 A1

**Description**

BACKGROUND OF THE INVENTION

Field of the Invention

The present invention relates to a stage apparatus, a lithography apparatus, and an article manufacturing method.

Description of the Related Art

In a manufacturing process for a semiconductor device, a liquid crystal display device, or the like, a stage apparatus for delivering a substrate by changing relative positions of a substrate chuck and pins each including a vacuum chuck mechanism for holding the substrate is used in some cases. Japanese Patent Application Laid-Open No. 2008-198755 discusses a stage apparatus that stores information about a position of a driven member when pins and a substrate are brought into contact with each other, and changes relative positions of the pins and the substrate at a high speed until the pins and the substrate are brought into contact with each other based on the stored positional information.

In this regard, Japanese Patent Application Laid-Open No. 2008-198755 discusses a technique for moving the driven member only a small distance at a low speed in a case where pins attract and hold a substrate chuck to separate the substrate from the substrate chuck. For example, if the driven member is moved at a high speed in a case where the substrate and the substrate chuck separate from each other, a horizontal displacement or the like of the substrate occurs due to a residual attraction force (force that prevents separation) between the substrate and the substrate chuck. This may cause abrasion of the substrate chuck. The residual attraction force is caused due to the characteristics of the substrate and the substrate chuck. Accordingly, it may be desirable to appropriately set a driving operation of the driven member in each case to separate the substrate and the substrate chuck from each other, while reducing the effect of the residual attraction force.

SUMMARY OF THE INVENTION

The present invention is directed to providing a stage apparatus suitable for delivering of a substrate from a substrate chuck to a pin.

According to a first aspect of the present invention, there is provided a stage apparatus as specified in claims 1 to 13. According to a second aspect of the present invention, there is provided a lithography apparatus as specified in claim 14. According to a third aspect of the present invention, there is provided an article manufacturing method as specified in claim 15.

Further features of the present invention will become apparent from the following description of embodiments with reference to the attached drawings.

BRIEF DESCRIPTION OF THE DRAWINGS

Fig. 1 is a schematic view illustrating a configuration example of a substrate processing apparatus according to a first embodiment.
Fig. 2 is a block diagram illustrating a configuration example of a control portion according to the first embodiment.
Fig. 3 illustrates a stage apparatus according to the first embodiment when viewed from a projection optical system (in +Z-direction).
Figs. 4A to 4C are sectional views of the stage apparatus according to the first embodiment.
Figs. 5A to 5C are sectional views of the stage apparatus according to the first embodiment.
Fig. 6 is a graph illustrating a relationship between time and a position of a driving portion (fine movement stage) in a Z-direction when a substrate is delivered from a substrate chuck to pins.
Fig. 7 is a graph illustrating a relationship between time and Z-deviation in the first embodiment.
Fig. 8 is a graph illustrating a relationship between time and the position of the driving portion (fine movement stage) in the Z-direction when the substrate is delivered from the substrate chuck to the pins according to the first embodiment.
Fig. 9 is a flowchart illustrating a substrate delivery method according to the first embodiment.
Fig. 10 is an example of a table illustrating second conditions related to first conditions according to a second embodiment.
Fig. 11 is a graph illustrating an example of a movement of the driving portion in the Z-direction according to the second embodiment.
Fig. 12 is a graph illustrating a relationship between time and the position of the driving portion (fine movement stage) in the Z-direction when the substrate is delivered from the substrate chuck to the pins according to a third embodiment.
Fig. 13 is a graph illustrating a relationship between time and the position of the driving portion (fine movement stage) in the Z-direction when the substrate is delivered from the substrate chuck to the pins according to a fourth embodiment.
Fig. 14 illustrates an example of a twin-stage configuration according to a fifth embodiment.
Fig. 15 is a flowchart illustrating an article manufacturing method according to a sixth embodiment.

DESCRIPTION OF THE EMBODIMENTS

Embodiments of the present invention will be described below with reference to the drawings. The following embodiments are not intended to limit the claimed invention. Not all the features described in the embodiments are necessarily deemed to be essential, and the features may be combined as needed. In the drawings, identical or similar components are denoted by the same reference numerals, and redundant descriptions are omitted. Each of the embodiments of the present invention described below can be implemented solely or as a combination of a plurality of the embodiments or features thereof where necessary or where the combination of elements or features from individual embodiments in a single embodiment is beneficial.

In the specification and the drawings, basically assume that a vertical direction is defined as a Z-axis, a horizontal plane perpendicular to the vertical direction is defined as an XY-plane, and each axis indicates a direction represented by XYZ coordinate systems orthogonal to each other. In this case, however, if XYZ coordinate systems are illustrated in the drawings, the coordinate systems are preferentially used.

A specific configuration of each embodiment will be described below.

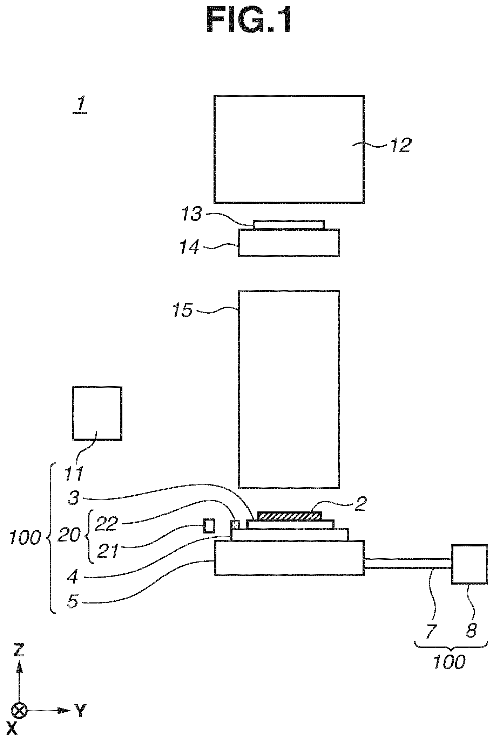

Fig. 1 is a schematic view illustrating a configuration example of a substrate processing apparatus 1 according to a first embodiment. In the first embodiment, the substrate processing apparatus 1 is a projection exposure apparatus that performs an exposure process on a substrate with a pattern of an original plate (mask, reticle) through a projection optical system by a step-and-repeat system or a step-and-scan system. However, the substrate processing apparatus 1 is not limited only to the projection exposure apparatus. For example, the substrate processing apparatus 1 may be a drawing apparatus that performs a drawing process on a substrate using electron beams, ion beams, or the like to form a pattern on the substrate. The substrate processing apparatus 1 may be another lithography apparatus (substrate exposure apparatus) such as an imprint apparatus that forms an imprint material on a substrate with a mold and forms a pattern on the substrate. The substrate processing apparatus 1 may be any other apparatus, including an ion implantation apparatus, a developing apparatus, an etching apparatus, a film formation apparatus, an annealing apparatus, a sputtering apparatus, and a deposition apparatus, which process a substrate such as a semiconductor wafer or a glass plate. More alternatively, the substrate processing apparatus 1 may be a planarization apparatus that planarizes a composition on a substrate using a flat plate.

The substrate processing apparatus 1 includes an illumination optical system 12 that radiates light, a projection optical system 15, a reticle stage 14 that holds a reticle 13, and a stage apparatus 100 configured to be able to hold a substrate 2. The stage apparatus 100 includes a substrate chuck (chuck plate) 3, a driving portion (fine movement stage) 4, a surface plate 5, a control portion 11, an exhaust line 7, a pressure adjustment portion 8, and a measurement portion 20. The control portion 11 controls a driving operation of the stage apparatus 100.

However, the control portion 11 may control not only the operation of the stage apparatus 100, but also the operation of each portion of the substrate processing apparatus 1. The exhaust line 7 connects pins to be described below to the pressure adjustment portion 8. The pressure adjustment portion 8 exhausts gas through the exhaust line 7 to adjust a pressure. This pressure adjustment enables the pins to attract and hold the substrate 2. While the present embodiment illustrates an example where the stage apparatus 100 includes the pressure adjustment portion 8, the stage apparatus 100 may not include the pressure adjustment portion 8, as long as the pressure to attract the substrate 2 to the pins can be adjusted.

The reticle 13 is an original plate having a configuration in which, for example, a pattern (e.g., a circuit pattern) to be transferred onto a surface of quartz glass is formed of chrome. The substrate 2 is, for example, monocrystalline silicon. If the substrate processing apparatus 1 is an exposure apparatus, the surface of the substrate 2 to be conveyed to the substrate processing apparatus 1 is coated with a photosensitive material (resist). In this case, the illumination optical system 12 is a pattern forming portion that forms a pattern on the substrate 2. In the present embodiment, a lithography apparatus that forms a pattern using light is described by way of example, and the pattern forming portion corresponds to the illumination optical system 12. Alternatively, a lithography apparatus that hardens a thermosetting material with heat may be used as the pattern forming portion. In this case, the pattern forming portion is, for example, a heating portion that heats the thermosetting material.

In the substrate processing apparatus 1, exposure light from a light source (not illustrated) is applied to the reticle 13, which is held on the reticle stage 14, through the illumination optical system 12. The light that has passed through the reticle 13 is irradiated on the substrate 2 through the projection optical system 15. In this case, the light from the pattern formed on the reticle 13 is focused on the surface of the substrate 2. The substrate processing apparatus 1 performs an exposure process on a shot region on the substrate 2, and also performs the exposure process on each of a plurality of shot regions.

If the substrate processing apparatus 1 is a substrate exposure apparatus of the step-and-scan system, the driving portion (fine movement stage) 4 is driven to thereby repeatedly perform a stepping operation on each shot region on the substrate 2 and a scanning operation. The driving portion (fine movement stage) 4 is also configured to be movable in a Z-axis direction and in a tilt direction, and is driven under control of the control portion 11. The stage apparatus 100 also includes the measurement portion 20 that measures a position of the driving portion 4. In the present embodiment, the measurement portion 20 uses a laser interferometer 21 to measure the position of the driving portion (fine movement stage) 4 with a laser beam reflected by bar mirrors 22. Each bar mirror 22 that reflects the laser beam from the laser interferometer 21 is provided at an end of the driving portion (fine movement stage) 4. One bar mirror 22 is located at a position along an X-axis direction, and another bar mirror 22 is located at a position along a Y-axis direction. At least one laser interferometer 21 is located at the position corresponding to the bar mirror 22 provided at the position along the X-axis direction and at the position corresponding to the bar mirror 22 provided at the location along the Y-axis direction. The bar mirror 22 provided at the position along the X-axis direction and the laser interferometer 21 located at the position corresponding to the bar mirror 22 measure the position in the X-direction and the position in the Z-direction of the driving portion (fine movement stage) 4. The bar mirror 22 provided at the position along the Y-axis direction and the laser interferometer 21 located at the position corresponding to the bar mirror 22 measure the position in the Y-direction and the position in the Z-direction of the driving portion (fine movement stage) 4. In the present embodiment, the bar mirrors 22 provided at the respective positions along the X-axis direction and the Y-axis direction, and the laser interferometers 21 located at the respective positions corresponding to the bar mirrors 22, measure the position in the Z-direction. Alternatively, the position in the Z-direction may be measured by one of the bar mirrors 22 provided at the respective positions along the X-axis direction and the Y-axis direction, or by another measurement portion to measure the position in the Z-direction. The bar mirrors 22 and the laser interferometers 21 for measuring the position in the Y-direction are not illustrated in Fig. 1. While the present embodiment illustrates an example where each bar mirror 22 is provided at an end of the driving portion (fine movement stage) 4, each bar mirror 22 may be provided on the substrate chuck 3. While the present embodiment illustrates a method in which the laser interferometer 21 is used to measure the position of the driving portion (fine movement stage) 4, an encoder may be used to measure the position of the driving portion 4. The method for measuring the position of the driving portion 4 is not particularly limited. In a configuration in which pins 6 are driven by the driving portion 4 to move (including movement of a leading edge of each pin 6 due to extension), the position of each pin 6 may be measured by the measurement portion 20.

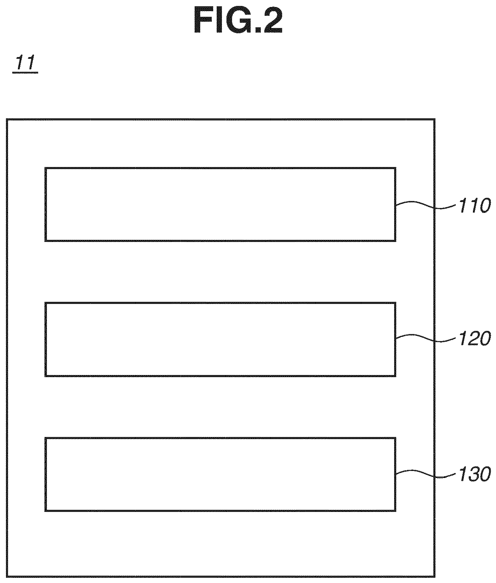

Fig. 2 is a block diagram illustrating a configuration example of the control portion 11 according to the present embodiment. The control portion 11 includes an instruction unit 110, a storage unit 120, and an information processing unit 130. The instruction unit 110 controls each portion. The functions of the storage unit 120 and the information processing unit 130 will be described below. While the present embodiment illustrates an example where the control portion 11 includes the storage unit 120 and the information processing unit 130, the storage unit 120 and the information processing unit 130 may be provided separately from the control portion 11.

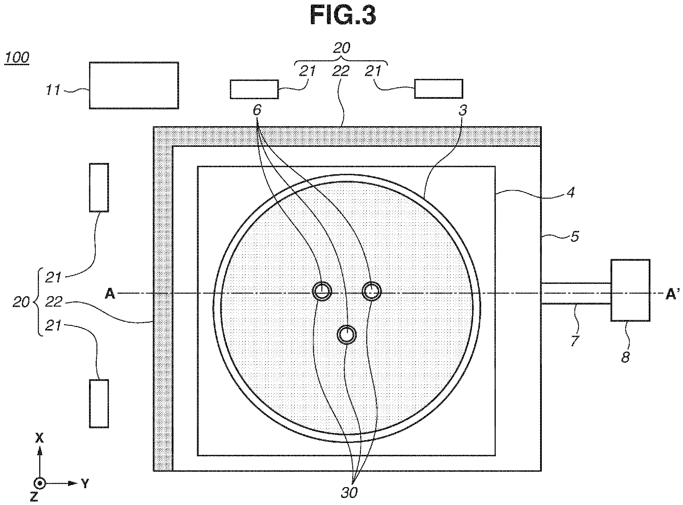

Fig. 3 illustrates the stage apparatus 100 according to the present embodiment when viewed from the projection optical system 15 (in +Z-direction). In the substrate chuck 3 according to the present embodiment, an annular seal portion is provided at a position along the outer periphery of the substrate chuck 3. The substrate chuck 3 may not be provided with the seal portion, or may be provided with a plurality of seal portions. The presence or absence of the seal portion, the number of the seal portions, and the layout of the seal portion are not limited to those in the example illustrated in Fig. 3.

The substrate chuck 3 is provided with a plurality of protrusions (not illustrated). The plurality of protrusions is configured to hold the substrate 2, and at least a part of the leading edges of the protrusions may function as a holding surface that holds the substrate 2. The substrate chuck 3 includes a plurality of attraction holes (not illustrated). Exhausting gas in a space between the substrate 2 and the substrate chuck 3 from the attraction holes allows the substrate chuck 3 to attract and hold the substrate 2. The pressure adjustment portion 8 may exhaust gas from the plurality of attraction holes. A pressure in the space between the substrate 2 and the substrate chuck 3 when the substrate chuck 3 attracts the substrate 2 is measured by a pressure sensor (not illustrated), and the exhaust of gas from the attraction holes in the substrate chuck 3 is adjusted based on a measured pressure value.

The surface plate 5 includes the pins 6 each having a hollow structure. The surface plate 5 also includes the exhaust line 7, and the exhaust line 7 connects the pins 6 and the pressure adjustment portion 8 to each other. In the example illustrated in Fig. 3, the pressure adjustment portion 8 is located outside of the surface plate 5, but instead may be located inside the surface plate 5. The substrate chuck 3 and the driving portion (fine movement stage) 4 are provided with through-holes (holes) 30 through which the pins 6 can protrude from the substrate chuck 3 (holding surface of the substrate chuck 3). While the present embodiment illustrates an example where three pins 6 are provided, the number of the pins 6 is not particularly limited, as long as the substrate 2 can be attracted and held. One bar mirror 22 is located along the X-axis direction and another bar mirror 22 is located along the Y-axis direction. Two laser interferometers 21 are located at the position corresponding to one of the bar mirrors 22, and two laser interferometers 21 are located at the position corresponding to the other of the bar mirrors 22.

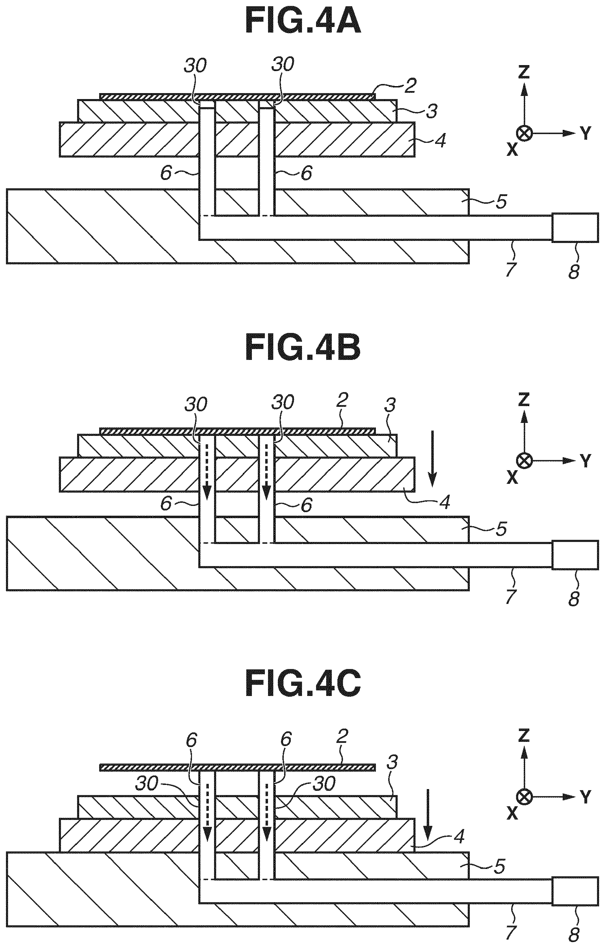

Figs. 4A to 4C are sectional views of the stage apparatus 100 according to the present embodiment. Figs. 4A to 4C are sectional views taken along a line A-A' in Fig. 3. In the examples illustrated in Figs. 4A to 4C, the driving portion (fine movement stage) 4 moves in the Z-axis direction along the pins 6. The driving portion 4 is configured to be movable in the Z-axis direction while being tilted based on the relationship among the positions in the Z-direction of the three pins 6.

In the example illustrated in Fig. 4A, the driving portion 4 is located in the +Z-direction and the substrate chuck 3 holds the substrate 2. In the example illustrated in Fig. 4B, the driving portion 4 moves in the -Z-direction, thereby bringing the pins 6 and the substrate 2 into contact with each other, and then the movement of the driving portion 4 is stopped. In this case, the attraction of the substrate 2 by the substrate chuck 3 is cancelled, the pressure adjustment portion 8 starts a pressure adjustment, and the pins 6 attract and hold the substrate 2. Then, the driving portion 4 further moves in the - Z-direction in a state where the substrate 2 is attracted and held by the pins 6 as illustrated in Fig. 4C. Thus, the substrate chuck 3 delivers the substrate 2 to the pins 6. As a result of operation illustrated in Fig. 4C, a gap is generated between the substrate chuck 3 and the substrate 2, and a conveyance hand (not illustrated) is inserted into this gap to convey the substrate 2 out of the stage apparatus 100.

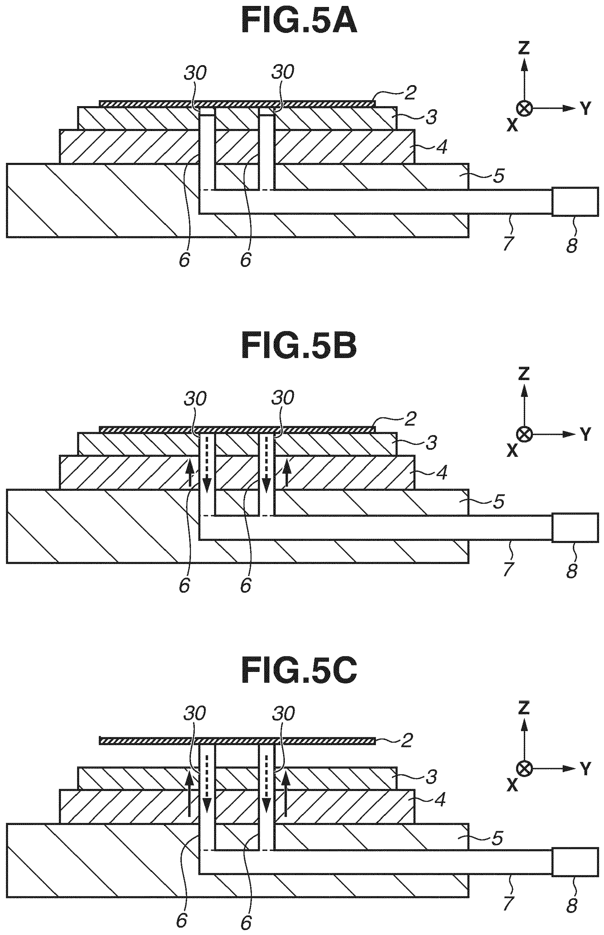

While Figs. 4A to 4C illustrate a configuration example where the movement of the driving portion (fine movement stage) 4 allows the pins 6 to attract and hold the substrate 2, any other configuration may be used as long as relative positions of the substrate chuck 3 and the pins 6 can be changed. For example, a configuration in which the driving portion 4 allows the entire portion or the leading edge of each pin 6 to move in the Z-direction may be used. Changing relative positions of the substrate chuck 3 and the pins 6 is synonymous with moving the substrate chuck 3 and the pins 6 relative to each other. The driving portion 4 may allow the substrate chuck 3 and the pins 6 to move relative to each other. Figs. 5A to 5C are sectional views of the stage apparatus 100 according to the present embodiment. Figs. 5A to 5C illustrate an example where the pins 6 are driven by the driving portion 4 and are extended, so that the leading edge of each pin 6 moves, thereby attracting and holding the substrate 2. In the present embodiment, the movement of the position of the leading edge of each pin 6 by the driving portion 4 may be expressed as movement of each pin 6.

In the example illustrated in Fig. 5A, the leading edge in the +Z-direction of each pin 6 is located in the -Z-direction and is not in contact with the substrate 2. In this state, the substrate chuck 3 holds the substrate 2. In the example illustrated in Fig. 5B, each pin 6 is extended in the +Z-direction, thereby bringing each pin 6 into contact with the substrate 2. The extension of each pin 6 at the position where the pins 6 are in contact with the substrate 2 is stopped to cancel the attraction of the substrate 2 by the substrate chuck 3. Then, the pressure adjustment portion 8 starts the pressure adjustment and the pins 6 attract and hold the substrate 2. Each pin 6 is further extended in the +Z-direction in a state where the pins 6 attract and hold the substrate 2 as illustrated in Fig. 5C. Thus, the substrate chuck 3 delivers the substrate 2 to the pins 6. As a result of operation illustrated in Fig. 5C, a gap is generated between the substrate chuck 3 and the substrate 2, and the conveyance hand (not illustrated) is inserted into this gap to convey the substrate 2 out of the stage apparatus 100. While Figs. 5A to 5C illustrate a configuration example where the extension of each pin 6 allows the substrate 2 to be delivered to the pins 6 from the substrate chuck 3, the driving portion 4 may allow the entire portion of each pin 6 to move in the Z-direction. The driving portion 4 may be included in each pin 6, or the driving portion 4 and each pin 6 may be connected to each other.

As illustrated in Figs. 4A to 4C and Figs. 5A to 5C, the control portion 11 controls the driving operation of the driving portion 4 configured to be able to move the substrate chuck 3 or the pins 6 so that the substrate 2 and the substrate chuck 3 can be separated from each other by a relative movement between the substrate chuck 3 and the pins 6. The operation of controlling the driving portion 4 to drive the substrate chuck 3 or the pins 6 is performed based on a first condition related to an attraction force (residual attraction force) between the substrate 2 and the substrate chuck 3 as described below. Also, the first condition is a condition related to easiness of separation between the substrate 2 and the substrate chuck 3. More specifically, the control portion 11 performs the control operation based on a second condition that is based on the first condition and is related to a relative movement (change in relative positions) between the substrate chuck 3 and the pins 6 when the substrate 2 is delivered to the pins 6. Delivering the substrate 2 to the pins 6 is synonymous with separating the substrate 2 and the substrate chuck 3 from each other. The second condition is related to at least one of an acceleration, a speed, or an amount of movement of the substrate chuck 3 or the pins 6 moved by the driving portion 4 during the relative movement between the substrate chuck 3 and the pins 6, and a standby time before the substrate 2 and the substrate chuck 3 separate from each other.

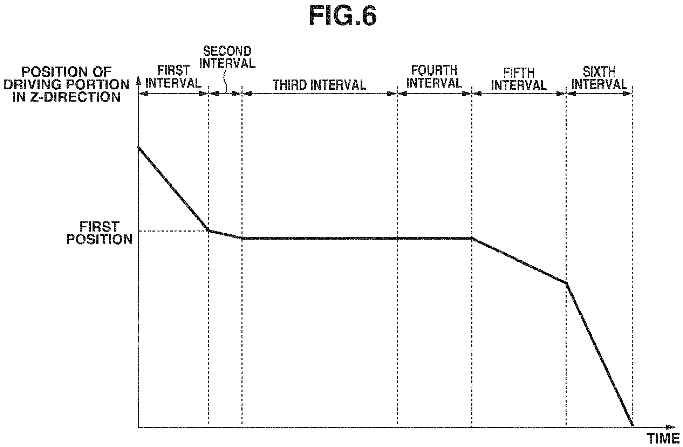

Fig. 6 is a graph illustrating a relationship between time and the position of the driving portion (fine movement stage) 4 in the Z-direction when the substrate 2 is delivered from the substrate chuck 3 to the pins 6. An amount of change in the position in the Z-direction of the driving portion (fine movement stage) 4 is similar to an amount of change in the position in the Z-direction of the substrate chuck 3. In a first interval, the instruction unit 110 controls the driving portion (fine movement stage) 4 to move in the -Z-direction at a high speed toward a first position that is stored in the storage unit 120 and is set as a target position. In a case where the driving portion (fine movement stage) 4 is driven in the -Z-direction, the first position is set at a position in the +Z-direction relative to the position in the Z-direction of the driving portion (fine movement stage) 4 when the substrate 2 is in contact with the pins 6, or is set at the same position.

Fig. 6 illustrates an example where the driving portion (fine movement stage) 4 moves in the -Z-direction. Also, in a case where the driving portion 4 for driving the pins 6 allows the entire portion or the leading edge of each pin 6 to move in the +Z-direction, the configuration illustrated in Fig. 6 in which the -Z-direction is replaced with the +Z-direction can be applied. This is because only the movement direction is different in this case. As for the case where the driving portion 4 for driving the pins 6 allows the entire portion or the leading edge of each pin 6 to move in the +Z-direction, the drawings to be described below and the following description can also be applied by replacing the -Z-direction with the +Z-direction. In this case, in the descriptions of Fig. 6 and other figures to be described below, the description of movement of the driving portion 4 in the Z-direction may be replaced with the description of movement of the substrate chuck 3 or the pins 6 by the driving portion 4, or may be replaced with the description of the relative movement between the substrate chuck 3 and the pins 6.

In a second interval, the driving portion 4 is moved in the -Z-direction at a low speed to monitor a drive current value in the driving operation of the driving portion 4. By monitoring the drive current value when the driving portion 4 is moved in the -Z-direction, the driving current value that changes when the substrate 2 and the pins 6 are brought into contact with each other is detected, and the contact between the substrate 2 and the pins 6 is detected.

In this case, the driving portion 4 is moved at a low speed in the second interval. This is because bringing the substrate 2 into contact with the pins 6 at a high speed may damage the substrate 2 and the pins 6.

When the contact between the pins 6 and the substrate 2 is detected by monitoring the drive current value, the movement of the driving portion 4 in the -Z-direction is stopped and the second interval ends. The position in the Z-direction of the driving portion 4 when the contact between the pins 6 and the substrate 2 is detected in the second interval may be set as the first position, and information about the first position stored in the storage unit 120 may be updated. Updating the first position as described above makes it possible to reduce time required for the second interval.

If the coordinates of the first position match the coordinates of the driving portion 4 when the substrate 2 and the pins 6 are brought into contact with each other, the substrate 2 and the pins 6 are in contact when the driving portion 4 is moved to the first position. In this case, simultaneously with the start of the second interval, the contact between the substrate 2 and the pins 6 is detected based on the drive current value. Accordingly, the operation transitions to a third interval without causing the driving portion 4 to move at a low speed in the second interval. If it is obvious that the coordinates of the first position match the coordinates of the driving portion 4 when the substrate 2 and the pins 6 are brought into contact with each other, the second interval may be omitted and the operation in the third interval may be carried out after the first interval.

In the third interval, suction of gas in the space between the substrate 2 and the substrate chuck 3 is stopped. In parallel with this operation, suction of gas in the space between the substrate 2 and the pins 6 by the pins 6 is started. In other words, the third interval corresponds to an attraction change interval.

A fourth interval is a standby interval for waiting until the pressure that has changed due to the attraction in the space between the substrate chuck 3 and the substrate 2 reaches the atmospheric pressure. This standby interval is an interval from when the suction of gas in the space between the substrate 2 and the substrate chuck 3 is stopped to when the driving portion 4 drives the substrate chuck 3 or the pins 6 to separate the substrate chuck 3 and the substrate 2 from each other, to thereby start the relative movement between the substrate chuck 3 and the pins 6. In this case, even after waiting for a certain period of time so that the pressure that has changed due to the attraction in the space between the substrate chuck 3 and the substrate 2 can reach the atmospheric pressure in the fourth interval, the pressure in the space between the substrate chuck 3 and the substrate 2 cannot reach the atmospheric pressure in some cases. This phenomenon may be caused due to, for example, a pressure loss failure or the characteristics of the substrate chuck 3 and the substrate 2. The term "residual attraction force" used in the present embodiment refers to the difference between the pressure and the atmospheric pressure when the pressure in the space between the substrate chuck 3 and the substrate 2 cannot reach the atmospheric pressure and the attraction force (attraction pressure) obtained when the substrate chuck 3 attracts and holds the substrate 2 remains. The residual attraction force is related to the easiness of separation between the substrate 2 and the substrate chuck 3. This residual attraction force makes it difficult to separate the substrate 2 from the substrate chuck 3 even when the decompression for the substrate chuck 3 to attract and hold the substrate 2 is stopped. This phenomenon is also called ringing. Examples of the characteristics of the substrate chuck 3 and the substrate 2 include an amount of warp of the substrate 2, surface roughness of the substrate 2 or the substrate chuck 3, and flatness of the substrate chuck 3. For example, when the roughness of the back surface of the substrate 2 and the roughness of the surface of the substrate chuck 3 that holds the substrate 2 are small, the substrate 2 and the substrate chuck 3 can be brought into close contact with each other. This makes it difficult to separate the substrate 2 from the substrate chuck 3. A state where the residual attraction force is high is synonymous with a state where the easiness of separation between the substrate 2 and the substrate chuck 3 is low.

Accordingly, in a fifth interval, the driving portion 4 is moved in the -Z-direction at a low speed to separate the substrate 2 from the substrate chuck 3 only a small distance. If the driving portion 4 is moved in the -Z-direction at a high speed to forcibly separate the substrate 2 and the substrate chuck 3 from each other in a state where the residual attraction force acts, a horizontal displacement or the like of the substrate 2 occurs on the substrate chuck 3, which causes abrasion of the substrate chuck 3. The abrasion of the substrate chuck 3 has adverse effects on the attraction and holding of the substrate 2 to be subsequently processed. For this reason, to reduce the abrasion of the substrate chuck 3, in the fifth interval, the driving portion 4 is moved in the -Z-direction at a low speed to thereby reduce the occurrence of a horizontal displacement or the like of the substrate 2 due to the residual attraction force. In a sixth interval, the driving portion 4 is moved in the -Z-direction at a high speed to reach a final position in the Z-direction.

As described above, the control portion 11 controls the substrate chuck 3 or the pins 6 to be moved by the driving portion 4 to move at a low speed in the fifth interval and to move at a speed higher than the speed in the fifth interval in the sixth interval. In other words, the speed at which the substrate chuck 3 or the pins 6 are moved by the driving portion 4 is controlled to change from a low speed to a high speed. This control operation may be performed by increasing the acceleration. Specifically, the control portion 11 controls the acceleration or the speed of the substrate chuck 3 or the pins 6 when the substrate 2 and the substrate chuck 3 separate from each other based on the interval between the substrate 2 and the substrate chuck 3.

In this case, execution of the processing on all substrates 2 under the same conditions in which the standby time in the fourth interval and the acceleration, the speed, and the amount of movement of the substrate chuck 3 and the pins 6 that are moved relative to each other by the driving portion 4 in the fifth interval are set to constant values may cause abrasion of the substrate chuck 3. This is because the residual attraction force is affected by the characteristics of the substrate 2 and the substrate chuck 3. For example, the possibility of occurrence of abrasion of the substrate chuck 3 can be reduced by increasing the standby time in the fourth interval for the substrate 2 on which the residual attraction force is more likely to be generated. The possibility of occurrence of abrasion of the substrate chuck 3 can also be reduced by decreasing the acceleration in the fifth interval (relative movement), decreasing the speed in the fifth interval (relative movement), or increasing the amount of movement in the fifth interval (relative movement). On the other hand, for the substrate 2 on which the residual attraction force is less likely to be generated, the standby time in the fourth interval is reduced, the acceleration in the fifth interval (relative movement) is increased, the speed in the fifth interval (relative movement) is increased, or the amount of movement in the fifth interval (relative movement) is reduced. This makes it possible to deliver the substrate 2 from the substrate chuck 3 to the pins 6 in a short period of time without causing abrasion of the substrate chuck 3. In other words, the substrate 2 can be delivered from the substrate chuck 3 to the pins 6 in a state where high productivity can be achieved. Accordingly, the present embodiment is directed to providing the stage apparatus 100 configured to be able to deliver the substrate 2 from the substrate chuck 3 to the pins 6 under conditions depending on the attraction force (residual attraction force, easiness of separation) between the substrate 2 and the substrate chuck 3 after the attraction of the substrate 2 is stopped.

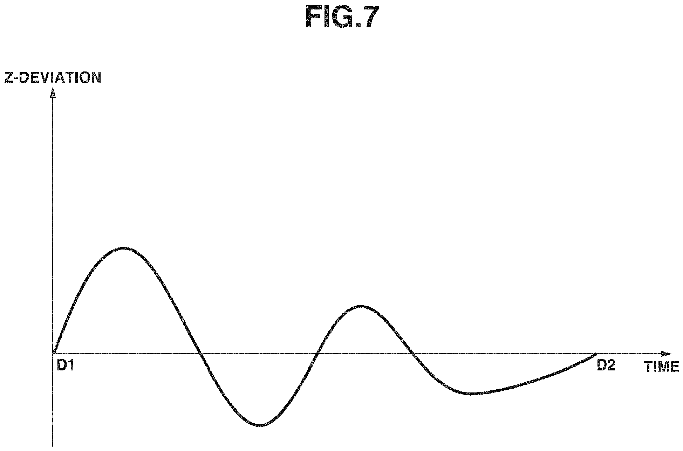

Fig. 7 is a graph illustrating a relationship between time and Z-deviation according to the present embodiment. In the present embodiment, time D1 is defined as a start time of the fifth interval (end time of the fourth interval), and time D2 is defined as an end time of the fifth interval (start time of the sixth interval). The Z-deviation refers to the difference between a target position in the Z-direction (driving direction) of the driving portion 4 and the actual position in the Z-direction of the driving portion 4 measured by the measurement portion 20 when the instruction unit 110 instructs the driving portion 4 to move in the Z-direction. If the measurement portion 20 measures the position of the substrate chuck 3, the difference between a target position in the Z-direction (driving direction) of the substrate chuck 3 and the actual position of the substrate chuck 3 measured by the measurement portion 20 corresponds to the Z-deviation. If the measurement portion 20 measures the position of each pin 6, the difference between a target position in the Z-direction (driving direction) of each pin 6 and the actual position of each pin 6 measured by the measurement portion 20 corresponds to the Z-deviation. In the present embodiment, the driving portion 4 is controlled based on the preliminarily obtained Z-deviation (first condition).

As described above, in a case where the driving portion 4 is moved in the -Z-direction at a low speed in the fifth interval after the standby state in the fourth interval, the residual attraction force makes it difficult to separate the substrate 2 from the substrate chuck 3.

This makes it difficult for the driving portion 4 to move to the target position indicated by the instruction unit 110 (makes it difficult for the substrate chuck 3 or the pins 6 to move to the target position), so that the target position and the actual position do not match in the Z-direction, which causes Z-deviation. The information processing unit 130 calculates the Z-deviation as the difference between the target position in the Z-direction of the driving portion 4, the substrate chuck 3, or the pins 6 and the actual position in the Z-direction measured by the measurement portion 20. The Z-deviation has, for example, a waveform as illustrated in Fig. 7.

In the present embodiment, an absolute value of the Z-deviation value when the obtained Z-deviation becomes a maximum value or a minimum value is defined as a Z-deviation representative value (first condition). The maximum value or the minimum value is a maximum value or a minimum value of the Z-deviation representative values (Z-deviations) obtained during a period from when the substrate 2 and the pins 6 are brought into contact with each other to when the entire surface of the substrate 2 is separated from the substrate chuck 3. The information processing unit 130 obtains an absolute value of the Z-deviation value when the Z-deviation is maximum or minimum in the obtained Z-deviation waveform, and stores the absolute value as the Z-deviation representative value in the storage unit 120.

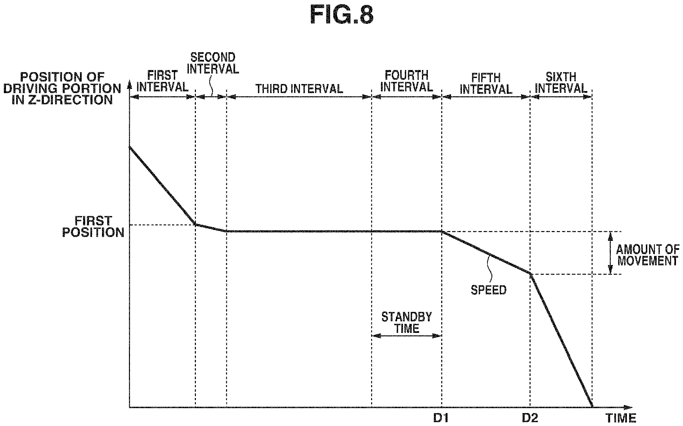

The instruction unit 110 gives an instruction to perform the driving operation by the driving portion 4 when the substrate chuck 3 or the pins 6 are moved to deliver the subsequent substrate 2 based on the Z-deviation representative value stored in the storage unit 120. Fig. 8 is a graph illustrating a relationship between time and the position of the driving portion (fine movement stage) 4 in the Z-direction when the substrate 2 is delivered from the substrate chuck 3 to the pins 6 in the present embodiment. In the case of instructing (controlling) the driving portion 4 to perform the driving operation, the instruction unit 110 performs the control operation based on the second condition based on the first condition (Z-deviation representative value) related to the easiness of separation stored in the storage unit 120. Specifically, the control operation based on the second condition is a control operation based on at least one of the standby time in the fourth interval, the acceleration or the speed in the fifth interval, and the amount of movement in the fifth interval of the member (substrate chuck 3 or pins 6) whose position can be changed by the driving portion 4. The amount of movement in the fifth interval is the amount of movement of the substrate chuck 3 or each pin 6 during a period from when the pin 6 contacts the substrate 2 to when the substrate chuck 3 or the pin 6 is moved at a predetermined speed when the substrate 2 and the substrate chuck 3 separate from each other. The predetermined speed is the speed at which the substrate chuck 3 or each pin 6 moves at a high speed in the sixth interval.

For example, a case where the attraction force (residual attraction force) is large or the Z-deviation representative value is large will be described. A case where the attraction force (residual attraction force) is large indicates a case where the easiness of separation is low. In this case, the difference between the target position in the Z-direction of the driving portion (fine movement stage) 4, the substrate chuck 3, or the pins 6 and the actual position thereof is large. Accordingly, the standby time in the fourth interval may be increased, the acceleration in the fifth interval (relative movement) may be decreased, the speed in the fifth interval (relative movement) may be decreased, or the amount of movement in the fifth interval (relative movement) may be increased. The effects of the residual attraction force may be reduced by adjusting one of the standby time in the fourth interval, the acceleration or the speed in the fifth interval, and the amount of movement in the fifth interval. Alternatively, the effects of the residual attraction force may be reduced by adjusting a plurality of conditions.

On the other hand, if the attraction force (residual attraction force) is small, an adjustment opposite to the above-described adjustment performed when the attraction force (residual attraction force) is large may be performed. A case where the attraction force (residual attraction force) is small indicates a case where the easiness of separation is high. If the attraction force is small, or if the Z-deviation representative value is small, the standby time in the fourth interval is reduced, the acceleration in the fifth interval (relative movement) is increased, the speed in the fifth interval (relative movement) is increased, or the amount of movement in the fifth interval (relative movement) is decreased. This control operation makes it possible to reduce time required for the fourth interval or the fifth interval, which leads to an improvement in productivity. The second condition based on the first condition according to the present embodiment may be determined such that the information processing unit 130 calculates the second condition to be adjusted based on the first condition. The instruction unit 110 may be configured to learn the type of each condition to be adjusted and the amount of adjustment and to perform the adjustment based on the learning result. Specifically, the control portion 11 may be configured to perform learning based on information about previous separation of the substrate 2 from the substrate chuck 3, and to determine the second condition to separate the subsequent substrate 2 from the substrate chuck 3 based on the leaning result.

A control operation based on the Z-deviation representative value will now be described. For example, substrates in the same lot tend to have similar characteristics. Accordingly, the Z-deviation representative value for a first substrate in the lot may be obtained and the driving operation of the driving portion 4 in the same lot may be controlled based on the obtained Z-deviation representative value. Alternatively, the Z-deviation representative values for all substrates may be obtained and the driving operation of the driving portion 4 may be controlled based on the obtained Z-deviation representative value on a substrate processed immediately before a substrate. More alternatively, the Z-deviation representative values for all substrates may be obtained, and if the Z-deviation representative value larger than the Z-deviation representative value stored in the storage unit 120 is obtained, the Z-deviation representative value stored in the storage unit 120 may be updated. More alternatively, the driving operation of the driving portion 4 may be controlled based on the maximum value of the Z-deviation representative values for the substrates that have been previously processed. Examples of the substrates that have been previously processed include substrates that have been previously processed in the same lot, substrates that have been previously processed under the same pre-process conditions, a plurality of substrates ranging from a substrate that has been processed before a predetermined number of substrates counting from a substrate to be subsequently processed to the previously processed substrate, and every predetermined number of substrates selected from among substrates that have been processed before a predetermined number of substrates counting from the substrate to be subsequently processed. Examples of every predetermined number of substrates selected from among substrates that have been processed before the predetermined number of substrates counting from the substrate to be subsequently processed include a substrate processed before processing of 15 substrates counting from the substrate to be subsequently processed, a substrate processed before processing of 10 substrates counting from the substrate to be subsequently processed, and a substrate processed before processing of five substrates counting from the substrate to be subsequently processed, in the case of calculating the Z-deviation representative value for every five substrates. The operation of the driving portion 4 may be controlled based on the Z-deviation representative values for these substrates. In other words, the Z-deviation representative values may be continuously or discontinuously obtained, and the instruction unit 110 may control the operation of the driving portion 4 based on one or more Z-deviation representative values. If the control operation is performed based on the Z-deviation representative values for a plurality of substrates, the operation of the driving portion 4 is controlled based on the maximum Z-deviation representative value among the Z-deviation representative values for the plurality of substrates, or the average value of the Z-deviation representative values for the plurality of substrates. In the present embodiment, the control operation is performed based on the first condition (Z-deviation, Z-deviation representative value). More specifically, the control operation is performed based on the second condition that is based on the first condition and is related to the relative movement between the substrate chuck 3 and the pins 6.

In a case where the instruction unit 110 controls the driving portion 4 based on the plurality of Z-deviation representative values, the Z-deviation representative values may be weighted by the information processing unit 130. Weighting may be performed in such a manner that, for example, the amount of weighting for substrates that have been processed at time closer to the time for the substrate to be subsequently processed can be increased. This is because it is highly likely that the substrates that have been processed at time closer to the time for the substrate to be subsequently processed have characteristics similar to those of the substrate to be subsequently processed. Alternatively, weighting may be performed by reflecting learning results of learning using an artificial intelligence (AI), machine learning, or the like.

Weighting is performed by, for example, multiplication of a weighting coefficient for weighting by the Z-deviation representative value. The driving portion 4 may be controlled based on the result of adding the weighted Z-deviation representative values. Depending on the weighting method, the driving portion 4 may be controlled based on the maximum value among the weighted Z-deviation representative values (Z-deviations) for the plurality of substrates, or the average value of the Z-deviation representative values for the plurality of substrates. The weighting method is not limited only to the above-described method. For example, a root-mean-square (RMS) may be used.

The present embodiment described above illustrates an example where the operation of the driving portion 4 is controlled based on the Z-deviation between time D1 and time D2. However, the operation of the driving portion 4 may be controlled based on the Z-deviation (first condition) during the period from the first to fourth intervals, or in at least some of the first to sixth intervals.

For example, in the case of controlling the operation of the driving portion 4 based on at least some of the first to fourth intervals, the driving portion 4 can be controlled not based on the substrate previously processed, but based on data on the substrate to be subsequently processed.

The present embodiment described above illustrates an example where the driving portion 4 is controlled based on the Z-deviation using the Z-deviation obtained when the driving portion 4 is moved in the Z-direction as the first condition. However, the first condition is not limited only to the Z-deviation (Z-deviation representative value). For example, the first condition may be X-deviation (X-deviation representative value) that is a deviation in the X-direction, or Y-deviation (Y-deviation representative value) that is a deviation in the Y-direction. Alternatively, the operation of the driving portion 4 may be controlled based on a value of a drive current flowing to the driving portion 4 when the driving portion 4 for moving the substrate chuck 3 or the pins 6 is driven to separate the substrate 2 and the substrate chuck 3 from each other. This operation utilizes the fact that the required drive current value increases when the residual attraction force is large, or when the easiness of separation is low. A value obtained when the drive current value is maximum can be used instead of the Z-deviation representative value. Alternatively, a load sensor may be located on a part of the driving portion 4, the pins 6, or the substrate chuck 3, and the operation of the driving portion 4 may be controlled based on a measured value obtained by measuring the load on the member where the load sensor is located when the substrate 2 and the substrate chuck 3 separate from each other. If the easiness of separation between the substrate 2 and the substrate chuck 3 is low, the value of the load sensor increases due to the effect of the residual attraction force. The value obtained when the value output from the load sensor is maximum can be used instead of the Z-deviation representative value. Alternatively, the pressure in the space between the substrate chuck 3 and the substrate 2 may be measured and the driving portion 4 may be controlled based on the measurement result. A value obtained when the difference between the pressure measurement result and the atmospheric pressure is maximum can be used instead of the Z-deviation representative value. More alternatively, the driving portion 4 may be controlled based on a value related to the control performance in at least some of the first to fourth intervals, such as the deviation, the drive current value, or the like in at least some of the first to fourth intervals. More alternatively, the operation of the driving portion 4 may be determined in advance based on the characteristics of the substrate chuck 3 and the substrate 2. Specifically, the operation of the driving portion 4 may be determined in advance based on the condition, such as the amount of warp of the substrate 2, the surface roughness of the substrate 2 or the substrate chuck 3, or the value of flatness of the substrate chuck 3, which is the characteristic of the substrate chuck 3 or the substrate 2. An information processing apparatus that is provided inside or outside of the substrate processing apparatus 1 and is different from the information processing unit 130 or the control portion 11 determines the operation of the driving portion 4 based on the characteristics of the substrate chuck 3 and the substrate 2. The above-described conditions may be used as the first condition.

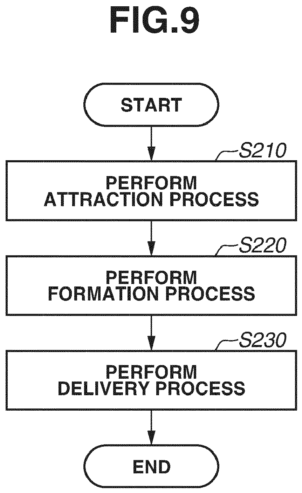

Fig. 9 is a flowchart illustrating a substrate delivery method according to the present embodiment. First, in step S210, an attraction process of attracting and holding the substrate 2 on the holding surface of the substrate chuck 3 is performed. In step S220, a formation process of forming a pattern on the substrate 2 attracted and held in the attraction process is performed.

Next, after the formation process, in step S230, a delivery process of delivering the substrate 2 attracted and held by the substrate chuck 3 from the substrate chuck 3 to the pins 6 is performed by a relative movement between the pins 6 and the substrate chuck 3. In the delivery process, the control portion 11 performs the control operation based on the first condition related to the easiness of separation between the substrate 2 and the substrate chuck 3. More specifically, the control portion 11 performs the control operation based on the second condition that is based on the first condition and is related to the relative movement between the substrate chuck 3 and the pins 6. The pins 6 are each configured to be able to attract and hold the substrate 2 and configured to be able to protrude from the substrate chuck 3 through the holes 30 in the substrate chuck 3.

According to the present embodiment, the driving operation of the driving portion 4 for causing the substrate chuck 3 and the pins 6 to move relative to each other is controlled in consideration of the easiness of separation between the substrate 2 and the substrate chuck 3, thereby making it possible to maintain high productivity while reducing the abrasion of the substrate chuck 3. Accordingly, the stage apparatus 100 according to the present embodiment is suitable for delivering the substrate 2 from the substrate chuck 3 to the pins 6.

A second embodiment differs from the first embodiment in regard to the second condition determination method. In the second embodiment, the Z-deviation representative value calculated by the information processing unit 130 is compared with a preset range of Z-deviation representative values, and the control portion 11 controls the driving portion 4 based on the second condition associated with the preset range of Z-deviation representative values.

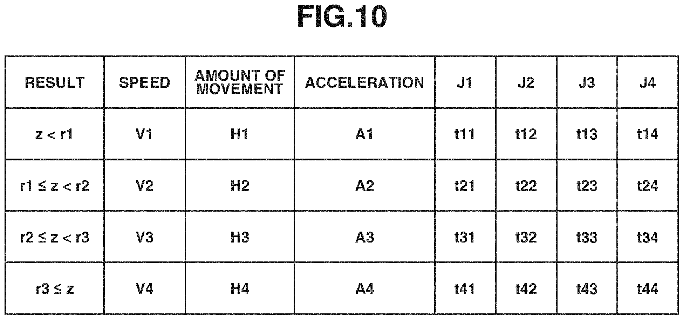

Fig. 10 is an example of a table indicating the second conditions related to the first conditions according to the present embodiment. In the present embodiment, the Z-deviation representative values are set as the first conditions and the Z-deviation representative values are divided into four ranges. As thresholds for the Z-deviation representative values, $r1$, $r2$, and $r3$ are set. For example, a case where the Z-deviation representative value is less than $r1$ will be described. In this case, the instruction unit 110 controls the driving portion 4 based on a speed $V1$ in the fifth interval, an amount of movement $H1$ in the fifth interval, an acceleration $A1$ in the fifth interval, and times $t11$, $t12$, $t13$, and $t14$ related to the acceleration in the fifth interval. The speed, the amount of movement, and the acceleration in the fifth interval and the time related to the acceleration are set as the second conditions. While Fig. 10 illustrates an example where only the second conditions in the fifth interval are set in advance, the standby time in the fourth interval may be set in advance as the second condition.

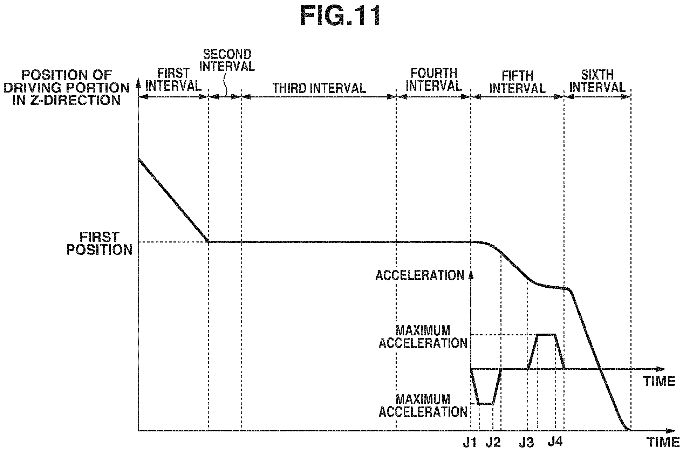

Fig. 11 is a graph illustrating an example of movement of the driving portion 4 in the Z-direction according to the present embodiment. If the control operation is performed based on the second condition associated with the range including the Z-deviation representative value, a waveform as illustrated in Fig. 11 can be obtained. Maximum accelerations illustrated in Fig. 11 correspond to an acceleration ($A1$, $A2$, $A3$, or $A4$) indicated in the table illustrated in Fig. 10. A time $J1$ indicates time when the acceleration in the -Z-direction is started, and the acceleration is continued until the maximum acceleration in the -Z-direction is obtained. When the maximum acceleration is reached, the acceleration becomes constant and the acceleration changes in a direction approaching "0" from time $J2$ when the acceleration changes toward "0". Until time $J3$, the acceleration is "0". From time $J3$, the acceleration in the +Z-direction is started. When the maximum acceleration in the +Z-direction is reached, the acceleration becomes constant and the acceleration changes in a direction approaching "0" from time $J4$ when the acceleration changes toward "0". The above-described times $t11$, $t12$, $t13$, and $t14$ correspond to, for example, times 11, $J2$, $J3$, and $J4$, respectively. However, the time related to the acceleration is not limited to these examples.

As described above, the control portion 11 performs the control operation based on a second condition set selected from a plurality of second condition sets preliminarily set based on the first condition. This eliminates the need for performing the operation (calculation) on each of the plurality of conditions. In the present embodiment, the speed, the amount of movement, the acceleration, and the time related to the acceleration are set in advance. However, the conditions are not limited to these examples, as long as the preliminarily set conditions include at least one of the above-described conditions.

While Fig. 10 illustrates an example where four levels of time related to the acceleration are set, the number of levels of time related to the acceleration is not limited to four.

The present embodiment described above illustrates an example where the second condition in the Z-direction is selected from among the plurality of condition sets preliminarily set based on the Z-deviation (Z-deviation representative value) using the Z-deviation (Z-deviation representative value) as the first condition. However, like in the first embodiment, any other value can be used as the first condition. For example, the first condition may be X-deviation (X-deviation representative value) that is a deviation in the X-direction, or Y-deviation (Y-deviation representative value) that is a deviation in the Y-direction. Alternatively, the first condition may be based on a drive current value for the driving operation of the driving portion 4. Alternatively, a load sensor may be located on a part of the driving portion 4, the pins 6, or the substrate chuck 3, and the first condition may be based on a value from the load sensor. More alternatively, the pressure in the space between the substrate chuck 3 and the substrate 2 may be measured and the first condition may be based on the measurement result. More alternatively, the first condition may be based on a value related to the control performance in at least some of the first to fourth intervals. More alternatively, the first condition may be based on characteristics of the substrate chuck 3 and the substrate 2. The above-described conditions may be used as the first condition.

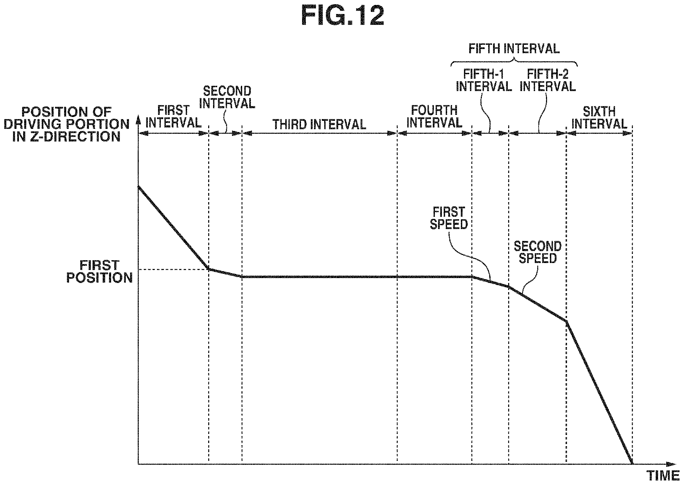

A third embodiment differs from the first embodiment in regard to the method of driving the driving portion 4 in the fifth interval. Fig. 12 is a graph illustrating a relationship between time and the position of the driving portion (fine movement stage) 4 in the Z-direction when the substrate 2 is delivered from the substrate chuck 3 to the pins 6 according to the present embodiment.

In the present embodiment, the fifth interval is divided into two intervals, i.e., a fifth-1 interval and a fifth-2 interval, to control the second condition. Specifically, the control portion 11 controls the substrate chuck 3 or the pins 6 to be moved by driving the driving portion 4 to move at a low speed in the fifth-1 interval and move at a high speed in the fifth-2 interval. In other words, the speed at which the substrate chuck 3 or the pins 6 are moved by driving the driving portion 4 is controlled to change from a low speed to a high speed in the fifth interval. While the present embodiment illustrates an example where the driving portion 4 moves in the -Z-direction to thereby separate the substrate 2 from the substrate chuck 3, the entire portion or the leading edge of each pin 6 may be moved in the +Z-direction by driving the driving portion 4, to thereby separate the substrate 2 from the substrate chuck 3.

If the substrate chuck 3 and the pins 6 are moved relative to each other by the driving portion 4 in the fifth interval after the fourth interval, which is the standby interval, the residual attraction force may be generated as described above. In other words, it may be difficult to separate the substrate 2 from the substrate chuck 3 (easiness of separation is low). To reduce the effects of the residual attraction force, it is desirable to decrease the speed of movement of the driving portion 4 in the -Z-direction in the fifth interval. However, decreasing the speed in the entire fifth interval leads to a decrease in productivity. For this reason, in the present embodiment, the driving portion 4 is moved at a low speed (first speed) in the -Z-direction in the fifth interval immediately after the fourth interval in which the effect of the residual attraction force is largest, that is, in the fifth-1 interval, and then the driving portion 4 is moved in the -Z-direction at a second speed higher than the first speed in the fifth-2 interval. The fifth interval is divided into two intervals, and the driving portion 4 is moved at a low speed in the first half of the fifth interval in which the effect of the residual attraction force is largest, and then the driving portion 4 is moved at a higher speed in the latter half of the fifth interval, thereby preventing deterioration in productivity while reducing the effect of the residual attraction force. While the present embodiment described above illustrates an example where the control operation is performed based on the fifth interval that is divided into two intervals, the fifth interval may be divided into three or more intervals and the control operation may be performed based on the three or more intervals. The control operation based on two or more intervals makes it possible to prevent deterioration in productivity while reducing the effect of the residual attraction force.

The third embodiment and the second embodiment may be combined, and the second condition in the Z-direction of the driving portion 4 may be selected from among a plurality of condition sets based on the first condition. For example, one second condition set is selected from among a plurality of second condition sets based on the first condition, and the movement of the driving portion 4 is controlled based on the speed in the fifth-1 interval and the speed in the fifth-2 interval set for the selected second condition set. The first condition may be one of Z-deviation (Z-deviation representative value), X-deviation (X-deviation representative value), Y-deviation (Y-deviation representative value), and the drive current value obtained when the driving portion 4 is driven. Alternatively, the first condition may be a measured value of a load sensor located on a part of the driving portion 4, the substrate chuck 3, or the pins 6, or a pressure value in the space between the substrate chuck 3 and the substrate 2. More alternatively, the first condition may be a value related to the control performance in at least some of the first to fourth intervals, characteristics of the substrate chuck 3 and the substrate 2, or the like. The combination of the third embodiment and the second embodiment eliminates the need for calculating each of the plurality of conditions.

A fourth embodiment differs from the first embodiment in regard to the method of controlling the driving portion 4 in the fifth interval.

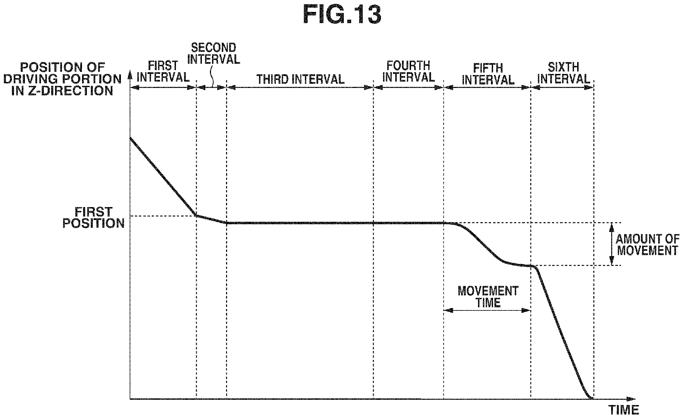

Fig. 13 is a graph illustrating a relationship between time and the position of the driving portion (fine movement stage) 4 in the Z-direction when the substrate 2 is delivered from the substrate chuck 3 to the pins 6 according to the present embodiment. In the fourth embodiment, the operation of the driving portion 4 in the fifth interval is controlled based on a target value (Z-position) based on a cosine waveform (cosine wave). The second condition based on the first condition makes it possible to determine the amount of movement and the movement time in the fifth interval. The cosine waveform is obtained based on the amount of movement in the fifth interval and the movement time in the fifth interval.

The cosine waveform can be calculated by the following expression (1), assuming that the initial position (first position) of the fifth interval is "0", the start time of the fifth interval is "0", an elapsed time from the start time of the fifth interval is represented by "t", the amount of movement in the fifth interval is represented by "z", and the movement time in the fifth interval is represented by "T".

$$z(t) = \frac{z}{2} \left( \cos\left(\frac{\pi}{T} * t\right) - 1 \right) \tag{1}$$

When the driving portion 4 is controlled based on the cosine waveform, the initial speed in the fifth interval becomes "0". This makes it possible to reduce the effects of the residual attraction force, for example, the abrasion of the substrate chuck 3. Further, when the driving portion 4 is controlled based on the cosine waveform, the driving operation of the driving portion 4 is performed as a single-frequency driving operation. This makes it possible to reduce the occurrence of local vibrations such as vibrations of the substrate 2.

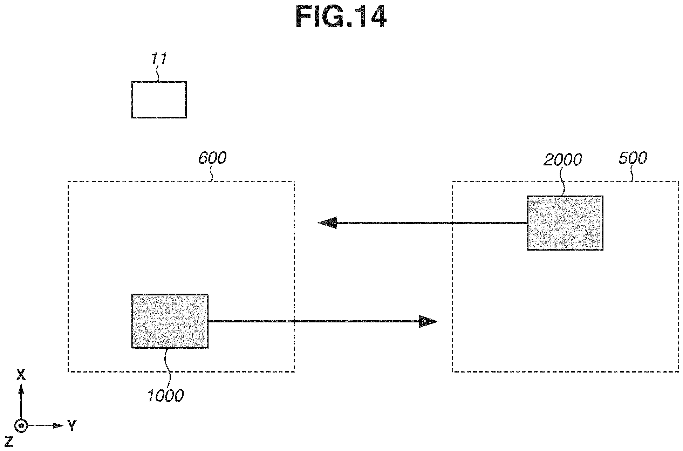

In a fifth embodiment, the features of the first embodiment are applied to a configuration using two or more stages, for example, a twin-stage configuration. Fig. 14 illustrates an example of a twin-stage configuration according to the fifth embodiment. The twin-stage configuration is composed of a first stage 1000 and a second stage 2000. The first stage 1000 and the second stage 2000 move between a measurement space 500 and an exposure space 600. The measurement space 500 is a space to measure an alignment mark. The exposure space 600 is a space in which an alignment process is performed based on the result of measurement in the measurement space 500 and an exposure process is performed on each shot region. The first stage 1000 and the second stage 2000 have a configuration similar to the configuration of the stage apparatus 100 described in the first embodiment. Specifically, the substrate chuck 3 holds the substrate 2, and the driving portion 4 is driven in the Z-direction to place the substrate 2 on the substrate chuck 3 or separate the substrate 2 from the substrate chuck 3.

A detailed operation of the twin-stage configuration will be described. After completion of the exposure process on the substrate 2 held on the first stage 1000 in the exposure space 600, the first stage 1000 moves to the outside of the exposure space 600. The substrate 2 on which the exposure process has been performed is delivered and the substrate 2 to be subjected to the exposure process is held. Then, the stage 1000 moves into the measurement space 500. On the other hand, the second stage 2000 moves into the exposure space 600 while the substrate 2 on which the alignment mark measurement process has been performed in the measurement space 500 is held. The alignment mark on the substrate 2 held on the first stage 1000 that has moved into the measurement space 500 is measured. Further, the substrate 2 held on the second stage 2000 that has moved into the exposure space 600 is aligned based on the alignment mark measurement result, and the exposure process is performed on each shot region.

In the present embodiment, the operation of the driving portion 4 for causing the substrate chuck 3 and the pins 6 to move relative to each other is controlled based on the first condition (second condition based on the first condition) on the first stage 1000 and the second stage 2000. Examples of the first condition include Z-deviation (Z-deviation representative value), X-deviation (X-deviation representative value), and Y-deviation (Y-deviation representative value). Other examples of the first condition may include a drive current value for the driving operation of the driving portion 4, a measured value of a load sensor located on a part of the driving portion 4, the substrate chuck 3, or the pins 6, and a measured value of a pressure in the space between the substrate chuck 3 and the substrate 2. Other examples of the first condition may include a value related to the control performance in at least some of the first to fourth intervals, and characteristics of the substrate chuck 3 and the substrate 2.

In the first embodiment, the operation of the driving portion 4 is controlled based on the first condition on one stage. The present embodiment illustrates an example where the control portion 11 controls the operation in the Z-direction of the driving portion 4 to move the substrate chuck 3 or the pins 6 on the first stage 1000 and the second stage 2000 based on the first condition (second condition based on the first condition) on the stage 1000. With this configuration, the operations of the first stage 1000 and the second stage 2000 can be appropriately performed based on information obtained from one of the stages, thereby making it possible to reduce the effects of the attraction force (residual attraction force, easiness of separation). The present embodiment is not limited to the example of controlling the first stage 1000 and the second stage 2000 based on the first condition (second condition based on the first condition) on the first stage 1000.

For example, only the first stage 1000 or only the second stage 2000 may be controlled based on the first condition (second condition based on the first condition) on the first stage 1000. The stage control operation may be performed based on the first condition (second condition based on the first condition) on the second stage 2000.

In another example of the present embodiment, the first stage 1000 and the second stage 2000 may be controlled by the first conditions (second conditions based on the first conditions) on the first stage 1000 and the second stage 2000, respectively. In this configuration, the control operation can be performed depending on the type of each stage even when the stages have different characteristics, respectively.

In still another example of the present embodiment, the first stage 1000 and the second stage 2000 may be controlled based on the first conditions (second conditions based on the first conditions) obtained on both the first stage 1000 and the second stage 2000. The residual attraction force is affected by the characteristics of each substrate 2 to be processed in many cases, and the substrates 2 in each lot may have different characteristics. In such cases, the first conditions tend to be similar in the same lot. Accordingly, the first stage 1000 and the second stage 2000 are controlled based on the first conditions (second conditions based on the first conditions) obtained on both the first stage 1000 and the second stage 2000. Specifically, for example, when the Z-deviation (Z-deviation representative value) is used as the first condition, Z-deviation Z1 is obtained on the first stage 1000, and when this value is maximum at the present stage, the value is used as the Z-deviation representative value. Next, Z-deviation Z2 is obtained on the second stage 2000, and when this value is larger than the Z-deviation Z1, the Z-deviation Z2 is used as the Z-deviation representative value. The first stage 1000 and the second stage 2000 are controlled using the second condition based on the Z-deviation Z2.

The above-described control operation makes it possible to control the relative movement between the substrate chuck 3 and the pins 6 in consideration of the easiness of separation between the substrate 2 and the substrate chuck 3 also in the twin-stage configuration. This configuration makes it possible to maintain high productivity while reducing the abrasion of the stage (substrate chuck).

A sixth embodiment illustrates an example of manufacturing an article using the stage apparatus 100 described above.

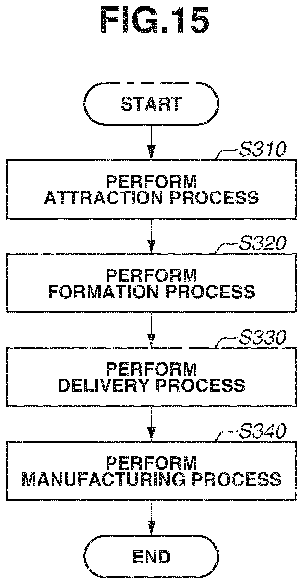

Fig. 15 is a flowchart illustrating an article manufacturing method according to the sixth embodiment. First, in step S310, an attraction process of attracting and holding the substrate 2 on the holding surface of the substrate chuck 3 is performed. In step S320, a formation process of forming a pattern on the substrate 2 attracted and held in the attraction process is performed.

Next, after the formation process, in step S330, a delivery process is performed to deliver the substrate 2 that is attracted and held by the substrate chuck 3 from the substrate chuck 3 to the pins 6 by the relative movement between the pins 6 and the substrate chuck 3. In the delivery process, the relative movement is performed based on the first condition related to the easiness of separation between the substrate 2 and the substrate chuck 3. The pins 6 are each configured to be able to attract and hold the substrate 2 and configured to be able to protrude from the substrate chuck 3 through the holes 30 in the substrate chuck 3. In step S340, a manufacturing process of manufacturing an article using the substrate 2 having the pattern formed in the formation process is performed.

Examples of the article manufactured by this manufacturing method include a semiconductor integrated circuit (IC) device, a liquid crystal display device, a color filter, and a micro-electro mechanical system (MEMS).

In the formation process, the pattern is formed on the substrate 2 in such a manner that, for example, the substrate 2 (silicon wafer, glass plate, etc.) coated with a photosensitive material is exposed to light by an exposure apparatus (lithography apparatus).

The manufacturing process includes processes of, for example, development of the substrate 2 with the pattern (photosensitive material) formed thereon, etching and resist peeling on the developed substrate 2, dicing, bonding, and packaging. According to this manufacturing method, it is possible to manufacture an article with the method that is advantageous in productivity and quality compared to the related art.

The present invention is not limited to the above-described embodiments, and various modifications and changes can be made without departing from the spirit and scope of the invention. Accordingly, the claims are attached to publicize the scope of the invention.

According to the present invention, it is possible to provide a stage apparatus suitable for delivering a substrate from a substrate chuck to a pin.

While the present invention has been described with reference to embodiments, it is to be understood that the invention is not limited to the disclosed embodiments. The scope of the following claims is to be accorded the broadest interpretation so as to encompass all such modifications and equivalent structures and functions.

## Claims

1. A stage apparatus (100) comprising:

   a substrate chuck (3) configured to attract and hold a substrate (2);
   a pin (6) configured to be able to attract and hold the substrate (2), the pin (6) being configured to be able to protrude from the substrate chuck (3) through a hole (30) in the substrate chuck (3);

a driving portion (4) configured to move one of the substrate chuck (3) and the pin (6) relative to the other of the substrate chuck (3) and the pin (6); and

a control portion (11) configured to control the driving portion (4),

wherein in a case where the substrate (2) and the substrate chuck (3) separate from each other, the control portion (11) controls the driving portion (4) based on a first condition related to easiness of separation between the substrate (2) and the substrate chuck (3).

2. The stage apparatus according to claim 1, wherein the control portion (11) controls the driving portion (4) based on a second condition related to the relative movement in a case where the substrate (2) and the substrate chuck (3) separate from each other, the second condition being set based on the first condition.

3. The stage apparatus according to claim 2, wherein the second condition includes at least one of an acceleration of the relative movement in a case where the substrate (2) and the substrate chuck (3) separate from each other, a speed of the relative movement, an amount of movement of one of the substrate chuck (3) and the pin (6) during a period from when the pin (6) contacts the substrate (2) to when one of the substrate chuck (3) and the pin (6) is moved at a predetermined speed, and a standby time from when suction of gas in a space between the substrate (2) and the substrate chuck (3) is stopped to when the relative movement is started.

4. The stage apparatus according to any one of claims 1 to 3, comprising a measurement portion (20) configured to measure a position of one of the driving portion (4), the pin (6), and the substrate chuck (3), wherein the first condition is related to a preset difference between a target position of a member including the measurement portion and a measurement result of a position of the member measured by the measurement portion (20) in a case where the driving portion (4) is driven.

5. The stage apparatus according to claim 4, wherein the first condition is related to a maximum value of the difference during a period from when the substrate (2) contacts the pin (6) to when an entire surface of the substrate (2) is separated from the substrate chuck (3).

6. The stage apparatus according to any one of claims 1 to 3, wherein the first condition is a value of a drive current flowing to the driving portion (4) in a case where the substrate (2) and the substrate chuck (3) separate from each other.

7. The stage apparatus according to claim any one of claims 1 to 3, further comprising a load sensor configured to measure a load on one of the driving portion (4), the pin (6), and the substrate chuck (3), wherein the first condition is a measured value of the load sensor in a case where the substrate (2) and the substrate chuck (3) separate from each other.

8. The stage apparatus according to any one of claims 1 to 3, further comprising a pressure sensor configured to measure pressure in a space between the substrate (2) and the substrate chuck (3), wherein the first condition is a measured value of the pressure sensor.

9. The stage apparatus according to any one of claims 1 to 3, wherein the first condition is related to at least one of an amount of warp of the substrate (2), surface roughness of one of the substrate and the substrate chuck (3), and flatness of the substrate chuck.

10. The stage apparatus according to claim 3, wherein the control portion (11) controls the driving portion (4) in such a manner that the acceleration of the relative movement in a case where the substrate (2) and the substrate chuck (3) separate from each other in a case where the easiness of separation is high is set to be larger than the acceleration in a case where the easiness of separation is low, the speed of the relative movement in a case where the easiness of separation is high is set to be higher than the speed in a case where the easiness of separation is low, the amount of movement of one of the substrate chuck (3) and the pin (6) during the period from when the pin contacts the substrate to when one of the substrate chuck (3) and the pin (6) is moved in a case where the easiness of separation is high is set to be smaller than the amount of movement in a case where the easiness of separation is low, or the standby time in a case where the easiness of separation is high is set to be shorter than the standby time in a case where the easiness of separation is low.

11. The stage apparatus according to any one of claims 1 to 10, wherein the control portion (11) controls one of an acceleration and a speed of one of the substrate chuck (3) and the pin (6) in a case were the substrate and the substrate chuck separate from each other based on an interval between the substrate and the substrate chuck.

12. The stage apparatus according to claim 2 or 3, further comprising:

a first stage (1000); and
a second stage (2000) different from the first stage,

wherein the control portion (11) controls at least one of the first stage (1000) and the second stage (2000) based on the first condition.

13. The stage apparatus according to claim 2 or 3, wherein the control portion (11) controls the driving portion (4) based on a result of weighting the first condition.

14. A lithography apparatus (1) comprising:

a stage apparatus (100) according to any one of claims 1 to 13; and
a pattern forming portion (12, 13, 14, 15) configured to form a pattern on a substrate (2) held on the stage apparatus (100).

15. An article manufacturing method comprising:

causing a substrate chuck (3) to attract and hold a substrate (2);
forming a pattern on the substrate (2) attracted and held by the substrate chuck (3);
delivering the substrate (2) attracted and held by the substrate chuck (3) from the substrate chuck to a pin (6) by a relative movement between the pin (6) and the substrate chuck (3), the pin (6) being configured to be able to attract and hold the substrate (2) and configured to be able to protrude from the substrate chuck (3) through a hole (30) in the substrate chuck (3) after the forming; and
manufacturing an article using the substrate (2) having the pattern formed,
wherein in the delivery, the relative movement is based on a first condition related to easiness of separation between the substrate (2) and the substrate chuck (3).

# FIG.1

# FIG.2

_11_

110

120

130

# FIG.3

# FIG.4A

# FIG.4B

# FIG.4C

# FIG.5A

# FIG.5B

# FIG.5C

# FIG.6

# FIG.7

# FIG.8

# FIG.9

```
           ┌─────────────┐
           │    START    │
           └──────┬──────┘
                  │        ╭─S210
                  ▼
    ┌──────────────────────────┐
    │         PERFORM          │
    │    ATTRACTION PROCESS     │
    └────────────┬─────────────┘
                 │        ╭─S220
                 ▼
    ┌──────────────────────────┐
    │         PERFORM          │
    │     FORMATION PROCESS     │
    └────────────┬─────────────┘
                 │        ╭─S230
                 ▼
    ┌──────────────────────────┐
    │         PERFORM          │
    │     DELIVERY PROCESS      │
    └────────────┬─────────────┘
                 │
                 ▼
           ┌─────────────┐
           │     END     │
           └─────────────┘
```

# FIG.10

| RESULT | SPEED | AMOUNT OF MOVEMENT | ACCELERATION | J1 | J2 | J3 | J4 |
|---|---|---|---|---|---|---|---|
| z < r1 | V1 | H1 | A1 | t11 | t12 | t13 | t14 |
| r1 ≤ z < r2 | V2 | H2 | A2 | t21 | t22 | t23 | t24 |
| r2 ≤ z < r3 | V3 | H3 | A3 | t31 | t32 | t33 | t34 |
| r3 ≤ z | V4 | H4 | A4 | t41 | t42 | t43 | t44 |

# FIG.11

# FIG.12

# FIG.13

POSITION OF DRIVING PORTION IN Z-DIRECTION

FIRST INTERVAL | SECOND INTERVAL | THIRD INTERVAL | FOURTH INTERVAL | FIFTH INTERVAL | SIXTH INTERVAL

FIRST POSITION

AMOUNT OF MOVEMENT

MOVEMENT TIME

TIME

# FIG.14

# FIG.15

START

↓ S310

PERFORM
ATTRACTION PROCESS

↓ S320

PERFORM
FORMATION PROCESS

↓ S330

PERFORM
DELIVERY PROCESS

↓ S340

PERFORM
MANUFACTURING PROCESS

↓

END

Europäisches
Patentamt

European
Patent Office

Office européen
des brevets

**EUROPEAN SEARCH REPORT**

Application Number

EP 24 15 8605

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | JP 2008 198755 A (CANON KK) 28 August 2008 (2008-08-28) | 1-4,6-15 | INV. H01L21/67 H01L21/683 |
| A | * paragraph [0011] - paragraph [0031]; figures 1-6 * | 5 | H01L21/687 |
| | ----- | | |

TECHNICAL FIELDS
SEARCHED      (IPC)

H01L

The present search report has been drawn up for all claims

| Place of search | Date of completion of the search | Examiner |
|---|---|---|
| The Hague | 17 June 2024 | Oberle, Thierry |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**EP 4 421 857 A1**

## ANNEX TO THE EUROPEAN SEARCH REPORT
## ON EUROPEAN PATENT APPLICATION NO.

EP 24 15 8605

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2024

| Patent document cited in search report | Publication date | Patent family member(s) | Publication date |
|---|---|---|---|
| JP 2008198755 A | 28-08-2008 | JP 4685041 B2<br>JP 2008198755 A | 18-05-2011<br>28-08-2008 |

EPO FORM P0459

For more details about this annex : see Official Journal of the European Patent Office, No. 12/82

32

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008198755 A